Europäisches Patentamt

European Patent Office

Office européen des brevets

(11) Publication number: **0 470 386 A2**

# EUROPEAN PATENT APPLICATION

(21) Application number: **91111480.9**

(22) Date of filing: **10.07.91**

(51) Int. Cl.⁵: **H01L 21/31**

(30) Priority: **08.08.90 JP 209768/90**

(43) Date of publication of application:
**12.02.92 Bulletin 92/07**

(84) Designated Contracting States:
**DE FR GB**

(71) Applicant: **SHIN-ETSU CHEMICAL CO., LTD.**
**6-1, Ohtemachi 2-chome**
**Chiyoda-ku Tokyo(JP)**

(72) Inventor: **Kashida, Meguru**
**3562-2, Annaka**
**Annaka-shi, Gunma-ken(JP)**
Inventor: **Nagata, Yoshihiko**
**3-13-37, Isobe**
**Annaka-shi, Gunma-ken(JP)**
Inventor: **Noguchi, Hitoshi**
**787-2, Yanase**
**Annaka-shi, Gunma-ken(JP)**

(74) Representative: **Raeck, Wilfrid, Dipl.-Ing.**
**Moserstrasse 8**
**W-7000 Stuttgart 1(DE)**

(54) **Method for depositing an inorganic thin film on a substrate.**

(57) The invention provides an improvement in the formation of a thin inorganic film, e.g. silicon carvbide, on a substrate plate, e.g., silicon wafer, by the method of CVD or sputtering as in the preparation of an X-ray lithographic mask membrane. In the inventive method, the substrate plate is held inside of the CVD or sputtering chamber on a holding plate of which at least the surface layer is made from a ceramic material formed by the CVD method so that the troubles of weld-bonding between the holding plate and the substrate at high temperatures can be fully avoided in addition to the advantage that the impurity content in the deposited thin film can be greatly decreased as compared with those prepared by using a holding plate made from a conventional material.

EP 0 470 386 A2

## BACKGROUND OF THE INVENTION

The present invention relates to a method for forming a thin film of an inorganic material on the surface of a substrate by the method of chemical vapor-phase deposition, referred to as CVD hereinbelow, or by the method of sputtering as in the preparation of a membrane used as a mask in the X-ray lithography.

As is known, the method of X-ray lighography is highlighted as a promising technology in the near future for fine patterning in the manufacture of various kinds of semiconductor devices along with the recent trend toward more and more increased fineness in patterning. The X-ray lithography is performed by using a membrane of an X-ray-permeable inorganic substance such as boron nitride, silicon carbide, silicon nitride and the like as a mask bearing a pattern formed of an X-ray-impermeable substance. Such a membrane of an X-ray-permeable substance is prepared by the deposition of a thin film of the substance on the surface of a substrate by the method of CVD or sputtering followed by removal of the substrate to leave the thin film in the form of an unsupported but framed membrane.

It is known that, in the deposition of an inorganic thin film on the substrate by the method of sputtering or thermal CVD or plasma CVD, the crystalline structure of the thin film deposited on the substrate surface is greatly influenced by the temperature of the substrate. When a silicon carbide film is deposited by the sputtering method, for example, the film deposited on a substrate at a relatively low temperature of room temperature to about 600 $^\circ$C is amorphous while the film deposited on a substrate at 600 $^\circ$C or higher is imparted with crystallinity so that a film having a high crystallinity and high purity can be obtained only on a substrate at a temperature of 600 $^\circ$C or higher or, preferably, 800 $^\circ$C or higher. While the substrate, such as a silicon wafer, is held inside of the sputtering chamber or CVD chamber by a holding and clamping device, called a "jig", accordingly, it is essential that the material of the jig can withstand the high temperature of 600 $^\circ$C or higher or, desirably, 800 $^\circ$C or higher in an atmosphere of vacuum.

General-purpose metals, such as iron, stainless steel, copper, aluminum and the like, are not suitable as the material of the above mentioned jig because, even when the temperature is substantially lower than the melting point of the metal, troubles are sometimes caused due to weld-bonding between the silicon wafer as a typical substrate material and the metal-made parts. So-called refractory metals, such as tungsten, molybdenum, gold, platinum and the like, having a sufficiently high melting point are not practical due to the relatively poor durability of the parts made therefrom even by setting aside the problem of expensiveness of the metal. Further, it is proposed to fabricate the jig from graphite or sintered ceramic material but these materials usually contain a considerably large amount of impurities which are responsible for the contamination of the thin film deposited on the substrate due to diffusion and infiltration of the impurity material into the film under the process of deposition.

## SUMMARY OF THE INVENTION

The present invention accordingly has an object to provide a novel and improved method for forming a thin film of an inorganic material deposited on the surface of a substrate by the method of chemical vapor-phase deposition or sputtering without the above described problems and disadvantages in the prior art methods, such as weld-bonding between the substrate and the jig, even when the temperature is 800 $^\circ$C or higher.

Thus, the method of the present invention for forming a thin film of an inorganic material deposited on the surface of a substrate by the method of chemical vapor-phase deposition or sputtering comprises: mounting a substrate plate on a holding plate and fixing the substrate plate thereto, at least the surface layer of the holding plate being formed by the deposition of a ceramic material by the method of chemical vapor-phase deposition; and exposing the surface of the substrate to an atmosphere of chemical vapor-phase deposition or sputtering to effect deposition of the inorganic material.

The above mentioned ceramic material is, preferably, boron nitride, silicon nitride, silicon carbide or a composite thereof or, more preferably, boron nitride.

## DETAILED DESCRIPTION OF THE PREFERRED EMBODIMENTS

As is understood from the above given description, the most characteristic feature of the inventive method consists in the use of a holding plate of the substrate which is made from a unique material heretofore not used for such a purpose.

The inorganic material, from which the thin film is deposited on the surface of a substrate by the method of CVD or sputtering, includes inorganic nitrides such as boron nitride BN, silicon nitride $Si_3N_4$, aluminum nitride AlN and the like, inorganic carbides such as silicon carbide SiC, boron carbide $B_4C$ and the like, diamond and so on. It is an established technique to deposit a composite of two kinds or more of these inorganic materials in the form of a thin film. Though not particularly limitative, high-purity silicon wafers are conveniently used as the substrate plate to be mounted on the holding plate.

The holding plate, which the substrate plate is mounted on and fixed to by clamping means, serves to evenly conduct the heat from the heater element located close to the other surface of the holding plate to the substrate plate. Accordingly, the holding plate should have plane dimensions somewhat larger than the substrate plate mounted thereon and a thickness in the range from 0.05 to 5 mm or, preferably, from 0.5 to 1.0 mm in order to ensure good balance between the mechanical strength and the uniformity in conduction of heat to the substrate plate.

It is an essential requirement for the holding plate that, in addition to the purity of the material as high as possible not to cause contamination of the thin film deposited, weld-bonding never takes place between the holding plate and the substrate plate even when the temperature thereof is increased eventually to exceed 800 °C. The inventors have conducted extensive studies in a trial-and-error manner and reached a conclusion that ceramic materials formed by the CVD method are quite satisfactory when used as a material of at least the surface layer of the holding plate and clamping means. The ceramic material suitable for the purpose is exemplified by boron nitride BN, silicon nitride $Si_3N_4$, silicon carbide SiC and the like either alone or as a composite of two kinds or more according to need. The ceramic material should desirably have a high purity containing 1 ppm or less of impurities. Such a high-purity ceramic material can readily be obtained by the CVD method.

It is of course that the holding plate or the clamping means is formed as a whole from the ceramic material deposited by the CVD method but it is sufficient in order to avoid weld-bonding with the substrate plate that the ceramic material is deposited by the CVD method on a core body of other heat-resistant materials forming the surface layer. For example, a core plate having a thickness of 0.05 to 5 mm is provided with a ceramic coating layer having a thickness of 0.01 to 0.5 mm by the CVD method without causing troubles due to warping or deformation of other types in the plate.

The CVD method applicable in the preparation of the holding plate and clamping means include the normal-pressure thermal CVD method, reduced-pressure thermal CVD method and plasma-induced thermal CVD method without particular limitation, of which, however, the reduced-pressure thermal CVD method is preferred in respect of the high purity and dense texture of the ceramic material deposited thereby as compared with the other methods. When the holding plate is prepared by the deposition of the ceramic material on a base plate, the material forming the base plate is preferably carbon in respect of the high heat resistance and easiness in stripping of the deposited ceramic layer off the base surface. It is usually necessary that the layer of the ceramic material deposited on the surface of the base plate is shaped by mechanical working into an appropriate form. Pyrolytic boron nitride, referred to as PBN hereinbelow, is preferred as the ceramic material in this regrad of mechanical workability as well as in respect of the high thermal conductivity. The heat source for the plate is not particularly limitative including infrared lamps, electric resistance heaters, high-frequency induction heaters and the like.

In the following, several embodiments of the present invention are described in more detail by way of examples and comparative examples which, however, never limit the scope of the invention in any way.

Example 1.

A silicon carbide disc as the target having a purity of 99.9% and a diameter of 3 inches and a thickness of 5 mm was set to serve as the cathode in the sputtering chamber of a high-frequency magnetron sputtering apparatus (Model SPF-332H, manufactured by Nichiden Anelva Co.). A silicon wafer having a diameter of 3 inches and a thickness of 600 $\mu$m polished on both surfaces to serve as the substrate plate was placed to face the target. The substrate was mounted on a holding plate having a diameter of 78 mm and a thickness of 1 mm and made from a material specified below, which was in contact with an infrared heater, and fixed to the holding plate by a clamping means using screws made from stainless steel.

The holding plate used here was made from PBN prepared by the reduced-pressure thermal CVD method, silicon carbide prepared by the reduced-pressure thermal CVD method using methyl trichlorosilane gas or silicon nitride prepared by the reduced-pressure CVD method using a gaseous mixture of silane and ammonia.

The pressure inside of the sputtering chamber was kept at 5.0 X $10^{-2}$ Torr by the balance of continuous evacuation and introduction of argon gas at a rate of 7 ml/minute as the carrier gas and the substrate was heated to a temperature mentioned below. A high-frequency electric power was applied between the target and the substrate in a power density of 10 watts per $cm^2$ area of the target surface to effect sputtering depositing a layer of silicon carbide on the substrate surface. After completion of sputtering taking 15 minutes to form a silicon carbide film having a thickness of 1.0 $\mu$m

deposited on the substrate surface, the substrate was cooled to room temperature and taken out of the sputtering chamber to examine the condition of weld-bonding between the holding plate and the substrate. The results were that absolutely no weld-bonding therebetween was detected in each of the five combinations of the material of the holding plate and the temperature of the substrate which was 800 °C, 1000 °C or 1200 °C for the PBN-made holding plate and 1000 °C for the silicon carbide- and silicon nitride-made holding plates.

Further, the contents of impurities were determined by the SIMS (secondary ion mass spectrometry) analysis for the surface of the silicon wafer as the substrate and for the thin film of silicon carbide deposited on the substrate. The results were that the total content of the impurities as detected by the method was smaller than 1 ppm in both of the substrate and the silicon carbide film in each of the combinations of the ceramic material and the temperature.

Comparative Example 1.

The experimental procedure was substantially the same as in Example 1 described above except that the material of the holding plate was, instead of the CVD-deposited ceramic materials, iron, stainless steel SUS 310-S, copper, aluminum, sintered silicon carbide or sintered silicon nitride and the temperature of the substrate was always 800 °C.

The results of the experiments were that weld-bonding was found between the holding plate and the substrate when the holding plate was made from iron, stainless steel, copper or aluminum while not when it was made from sintered silicon carbide or silicon nitride body. The results of the impurity determination were that the total contents of the impurities were 800 ppm in the silicon wafer substrate and 180 ppm in the silicon carbide film when the holding plate of sintered silicon carbide was used and 1200 ppm in the silicon wafer substrate and 300 ppm in the silicon carbide film when the holding plate of sintered silicon nitride was used.

Example 2 and Comparative Example 2.

A silicon wafer having a diameter of 75 mm and a thickness of 600 $\mu$m as the substrate was mounted, in a CVD chamber, on a 100 mm by 100 mm wide holding plate, of which the surface layer was made from silicon carbide deposited by the CVD method in the same manner as in the preparation of the silicon carbide-made holding plate used in Example 1. The silicon wafer was fixed to the holding plate using a clamping means with screws of stainless steel coated with silicon nitride.

Concurrently, the same assembly as above was additionally set in the CVD chamber except that the holding plate was made from sintered silicon carbide as in the Comparative Example 1.

While keeping the pressure inside of the CVD chamber at 0.8 Torr, a gaseous mixture of dichlorosilane, propane and hydrogen was introduced into the chamber at rates of 200 ml/minute, 300 ml/minute and 2000 ml/minute, respectively, to effect thermal CVD reaction at 1100 °C for 10 minutes to form a silicon carbide film having a thickness of about 3.0 $\mu$m on each of the silicon wafers.

After cooling, the silicon wafers were taken out of the chamber and examined to find no weld-bonding with each of the holding plates, one, coated with silicon carbide formed by the CVD method and, the other, made from sintered silicon carbide. The results of the impurity determination were that the total content of impurities was less than 1 ppm in the silicon carbide film deposited on the silicon wafer when the holding plate was coated by the CVD silicon carbide layer while the total impurity content in the silicon carbide film was 250 ppm when the holding plate was made from sintered silicon carbide.

**Claims**

1.  A method for forming a thin film of an inorganic material deposited on the surface of a substrate by the method of chemical vapor-phase deposition or sputtering, which comprises: mounting a substrate plate on a holding plate and fixing the substrate plate thereto, at least the surface layer of the holding plate being formed by the deposition of a ceramic material by the method of chemical vapor-phase deposition; and exposing the surface of the substrate to an atmosphere of chemical vapor-phase deposition or sputtering to effect deposition of the inorganic material.

2.  The method for forming a thin film of an inorganic material deposited on the surface of a substrate as claimed in claim 1 in which the ceramic material formed by the method of chamical vapor-phase deposition is selected from the group consisting of boron nitride, silicon nitride, silicon carbide and composites thereof.